# EUROPÄISCHE PATENTSCHRIFT

(11) **EP 0 489 785 B1**
(45) Veröffentlichungstag und Bekanntmachung des Hinweises auf die Patenterteilung: **02.11.1994**
(21) Anmeldenummer: 90912796.1
(22) Anmeldetag: 22.08.1990
(51) Int. Cl.: H03M 5/14, G11B 20/14, H04L 7/033

(54) **VERFAHREN ZUR ERKENNUNG EINES NUTZSIGNALS UND SCHALTUNG ZUR DURCHFÜHRUNG DES VERFAHRENS**
METHOD FOR THE RECOGNITION OF THE WANTED SIGNAL AND CIRCUIT FOR CARRYING OUT THE METHOD
PROCEDE DE RECONNAISSANCE DE SIGNAUX UTILES ET CIRCUIT POUR LA MISE EN OEUVRE DU PROCEDE

(30) Priorität: 30.08.1989 DE 3928676
(43) Veröffentlichungstag der Anmeldung: 17.06.1992
(73) Patentinhaber: DEUTSCHE THOMSON-BRANDT GMBH, 78048 Villingen-Schwenningen (DE)
(72) Erfinder: SCHOLZ, Werner, D-3007 Gehrden (DE)
(86) Internationale Anmeldenummer: EP9001390
(87) Internationale Veröffentlichungsnummer: WO9103879

## Beschreibung

Die Erfindung geht aus von einem Verfahren gemäß dem Oberbegriff des Anspruchs 1.

Bei der Übertragung digitaler Signale wird oft eine zuverlässige Information darüber benötigt, ob es sich bei einem binären Eingangssignal um ein Nutzsignal oder lediglich um verstärkte und begrenzte Störsignale handelt. Dabei ist angenommen, daß das Eingangssignal in binärer Form vorliegt, d.h. am Ausgang von Eingangsverstärker, Entzerrer und Pegeldetektor verfügbar ist.

Eine derartige Erkennungsschaltung für ein Nutzsignal ist z.B. vorteilhaft anwendbar bei einer PLL-Schaltung mit einem Zählphasendiskriminator gemäß der DE-OS 36 34 751. In dieser Schaltung muß sichergestellt werden, daß während der Zeiten ohne Nutzsignal die Einstellung eines Vor/Rück-Zählers nicht verändert wird, da dadurch eine Änderung der Mittenfrequenz des VCO-Oszillators der PLL und damit eine verlängerte Einlaufzeit der PLL bei Beginn der nächsten Nutzsignalzeit verursacht würde.

In einer PLL-Schaltung gemäß der älteren PCT-Anmeldung WO 90/13121 muß ebenfalls zwischen Nutzsignalzeiten und Totzeiten unterschieden werden. Hier erfolgt die Umschaltung mit Hilfe einer von der Kopfradumdrehung abgeleiteten Schaltspannung. Diese Lösung kann ebenso wie bei der eingangs genannten bekannten Schaltung zu unerwünschten Verstimmungen des VCO-Oszillators führen, und zwar dann, wenn in der Zeit des Band/Kopf-Kontaktes statt des Nutzsignals nur Störsignale geliefert werden. Der Fall kann z.B eintreten, wenn ein unbespielter Bereich des Bandes abgetastet wird, wenn bei der Aufnahme oder bei der Wiedergabe einer der Köpfe vorübergehend verschmutzt war oder ist oder bei Spurführungsfehlern.

Der Erfindung liegt die Aufgabe zugrunde, ein einfaches, mit digitalen Bausteinen realisierbares Verfahren zur sicheren Erkennung eines Nutzsignals in einem binären Signal zu schaffen.

Diese Aufgabe wird durch die im Anspruch 1 angegebene Erfindung gelöst. Eine Schaltung zur Durchführung des Verfahrens ist im Anspruch 2 angegeben. Die im Anspruch 1 genannte Zahl unmittelbar aufeinanderfolgender gleichwertiger Bits wird im folgenden mit "Runlength" bezeichnet.

Die Erfindung beruht auf der Erkenntnis, daß bei einem aus Störsignalen erzeugten Binärsignal der Runlength-Bereich des Nutzsignals in verhältnismäßig kurzen Zeitabständen überschritten wird. Diese Tatsache wird erfindungsgemäß dazu ausgenutzt, um eine das Nutzsignal oder das Störsignal anzeigende Stellgröße zu erzeugen. Eine Schaltung nach dem erfindungsgemäßen Verfahren arbeitet besonders zuverlässig und schnell und ist als reine Digitalschaltung leicht integrierbar. Ein wesentlicher Vorteil der Nutzsignalerkennung direkt aus dem Eingangssignal besteht auch darin, daß die Zuleitung eines externen Nutzsignal-Markiersignals z.B. von der Kopfumschaltung, vom Kanaldecoder oder der Dropout-Erkennung entfällt.

Die Erfindung wird anhand der Zeichnung näher erläutert. Darin zeigen
- Fig. 1: ein Ausführungsbeispiel einer Schaltung für das erfindungsgemäße Verfahren und
- Fig. 2: die Anwendung der Schaltung nach Fig. 1 bei der eingangs beschriebenen bekannten Schaltung mit einem Zählphasendiskriminator.

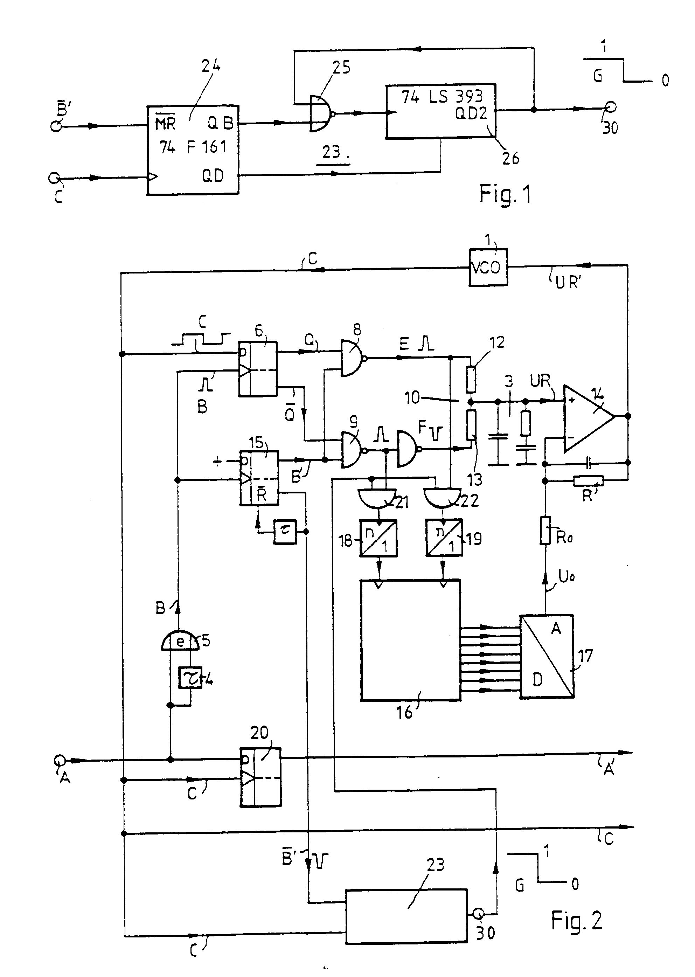

Die in Fig. 1 dargestellte Schaltung ist besonders geeignet für Binärsignale in 8/10-Modulation mit einer maximalen Runlength von 6 bei Bitraten bis zu ca 50 MBit/s. Der Zähler 24 überwacht die Runlength des ankommenden Binärsignals B′. Der Zähler 24 wird bei jedem Pegelübergang des Eingangssignals zurückgesetzt. Der Ausgang QD kann nur dann auf 1 gehen und damit den die zweite Stufe bildenden Zähler 26 zurücksetzen, wenn zwischen zwei Pegelübergängen des Eingangssignals B′ mindestens 8 Taktimpulse C liegen. Dabei braucht der Takt nicht mit dem Eingangssignal synchronisiert zu sein.

Der Zähler 26 überwacht den Abstand zwischen den Runlength-Überschreitungen, die in dem Zähler 24 ermittelt werden. Der Zählbereich des Zählers 26 ist der maximalen Größe dieses Abstandes in den Totzeiten des Signals angepaßt. Der Ausgang des Zählers 26 geht hier jeweils nach 128 Impulsen vom Ausgang des NOR-Gatters 25 auf 1, wenn nicht in der Zwischenzeit infolge einer Runlength-Überschreitung eine Rücksetzung erfolgt. Diese Rücksetzungen erfolgen in genügend kurzen Abständen während der Totzeiten des Signals, so daß die am Ausgang 30 erzeugte, das Nutzsignal oder das Störsignal anzeigende Stellgröße G auf null bleibt. Die Stellgröße G kann, wie anhand der Fig. 2 noch erläutert, eine gewünschte Umschaltung zwischen Betrieb für ein Nutzsignal und Betrieb für ein reines Störsignal vornehmen. Die Zahl der Taktimpulse C, die zwischen zwei Runlength-Überschreitungen maximal liegen dürfen, beträgt hier ca 4 x 128 = 512, da der Zählimpuls für den Zähler 26 vom zweiten Flip-Flop des Zählers 24 abgenommen wird.

Bei einem weitestgehend störungsfreien Nutzsignal kann die Runlength nicht mehr den Wert 8 erreichen. Dann geht der Ausgang 30 des Zählers 26 auf 1 und sperrt das Gatter 25, so daß dieser Zustand bestehenbleibt und nur durch Rücksetzen des Zählers 26 infolge einer Runlength-Überschreitung beendet werden kann. Das Signal G=1 sorgt dafür, daß der Vor/Rückzähler 16 in Fig. 2 arbeitet und die Mittenfrequenz des Oszillators 1 ständig auf den Optimalwert eingestellt ist.

Jede Runlength-Überschreitung bedeutet, daß das momentane Signal nicht für die Nachregelung der Frequenz eines Oszillators geeignet ist. Daher wird die Nachregelung sofort durch Rücksetzen des Zählers 26 unterbrochen und erst nach Feststellung einwandfreier Signalverhältnisse wie beschrieben wieder fortgesetzt.

Fig. 2 zeigt eine Anwendung der in Fig. 1 dargesstellten Schaltung 23 für eine bekannte PLL-Schaltung mit Zähl-Phasendiskriminator gemäß der DE-OS 36 34 751. Mit Hilfe des EXOR-Gatters 5 und des Verzögerungsgliedes 4 wird aus jedem Pegelübergang des binären Eingangssignals A ein schmaler Impuls B′ erzeugt. Das Flip-Flop 15 erzeugt ebenfalls Impulse B′ bestimmter Breite. Es dient lediglich als Laufzeitausgleich für das Flip-Flop 6, das zur Erzeugung einer Umschaltspannung Q dient. Die Umschaltspannung bewirkt, daß die Impulse B entweder dem Ausgang des Gatters 8 oder 9 zugeführt werden. Sie ist davon abhängig, ob der Impuls B vor oder hinter der abfallenden Flanke der Ausgangsspannung C des VCO-Oszillators 1 beginnt.

Die Ausgangsspannung E des Gatters 8 und die invertierte Ausgangsspannung F des Gatters 9 werden mit Hilfe der Widerstände 12 und 13 zwecks Erzeugung der Regelspannung UR addiert. Das Netzwerk 3 bewirkt eine Tiefpaßfilterung von UR. Über den Verstärker 14 wird UR dem Oszillator 1 als Regelspannung UR′ zugeführt. Das Niveau der Regelspannung und damit die Mittenfrequenz des Oszillators 1 werden durch die Ausgangsspannung Uo des D/A-Wandlers 17 bestimmt. Das Eingangssignal für den D/A-Wandler 17 liefert der Vor/Rückzähler 16. Dieser erhält seine Zählimpulse über die Frequenzteiler 18 und 19, sofern die Gatter 21, 22 nicht gesperrt sind. Die Schaltung 23 zur Erkennung des Nutzsignals bewirkt, daß die Gatter 21 und 22 nur dann geöffnet sind, wenn das binäre Eingangssignal A ein Nutzsignal ist.

Bei einem binären Nutzsignal A treten die Pegelübergänge gehäuft im Abstand von ganzzahligen Vielfachen der Bitdauer auf. Bei gleichen Frequenzteilern 18 und 19 verändert sich Uo solange, bis die Impulszahlen an den Ausgängen der Gatter 8 und 9 im Mittel übereinstimmen. Dieses bedeutet aber, daß die Pegelübergangshäufungen, die z.B. das Augendiagramm anschaulich zeigt, symmetrisch um jeweils einen Pegelübergang der Ausgangsspannung C des Oszillators 1 angeordnet sind.

Bei gleich langen Halbwellen der Spannung C muß dann der andere Pegelübergang in Augenmitte liegen und damit für die fehlerfreie Abtastung des binären Eingangssignals geeignet sein. Die Abtastung des Signals A erfolgt hier mit Hilfe der positiven Flanke von C im Flip-Flop 20.

## Patentansprüche

1. Verfahren zum Erzeugen einer ein Nutzsignal anzeigenden Stellgröße (G) aus einer binären Signalfolge mit abwechselnden Nutzsignalen und Störsignalen, wobei die Stellgröße (G) mit einem ersten Wert (1) anzeigt, daß ein binäres Nutzsignal vorliegt, und mit einem zweiten Wert (O) anzeigt, daß ein während eines Signalausfalls durch Verstärkung und Begrenzung erzeugtes binäres Störsignal vorliegt, wobei beim Nutzsignal die Anzahl der unmittelbar aufeinanderfolgenden gleichwertigen Bits innerhalb eines vorgegebenen Bereiches liegt, **dadurch gekennzeichnet**, daß die Anzahl der unmittelbar aufeinanderfolgenden gleichwertigen Bits der Signalfolge (A) gemessen wird und nach einer Überschreitung der oberen Grenze des vorgegebenen Bereichs die Stellgröße (G) mit dem zweiten Wert (O) erzeugt wird und daß die Stellgröße (G) auf den ersten Wert zurückgestellt wird, sobald der zeitliche Abstand zwischen zwei Überschreitungen des vorgegebenen Bereichs einen vorgegebenen Wert übersteigt.

2. Schaltung zur Durchführung des Verfahrens nach Anspruch 1, **dadurch gekennzeichnet**,daß ein erster Zähler (24) für aufeinanderfolgende gleichwertige Bits des Signals und ein zweiter Zähler (26) für den zeitlichen Abstand der im ersten Zähler (24) ermittelten Überschreitungen vorgesehen sind, daß ein Ausgang (QB) des ersten Zählers (24) mit dem ersten Eingang eines NOR-Gatters (25), dessen Ausgang mit dem Eingang des zweiten Zählers (26) und dessen Ausgang (30) mit dem zweiten Eingang des NOR-Gatters (25) verbunden ist, und daß der erste Zähler (24) bei jedem Pegelübergang des binären Signals zurückgesetzt oder auf einen bestimmten Stand voreingestellt wird und der zweite Zähler (26) zurückgesetzt wird, sobald der erste Zähler (24) einen vorgegebenen Zählerstand erreicht.

## Claims

1. A method of generating a control quantity (G), which indicates a useful signal, from a binary signal sequence with alternating useful signals and disturbance signals, wherein the correcting variable (G) indicates with a first value (1) that a binary useful signal is present and indicates with a second value (0) that a binary disturbance signal, generated during a signal drop-out as a result of amplification and delimitation, is present, wherein in the case of the useful signal the number of directly consecutive equivalent bits falls within a given range, characterised in that the number of directly consecutive, equivalent bits of the signal sequence (A) is measured and following an overshooting of the upper limit of the given range the control quantity (G) is generated with the second value (0), and that the control quantity (G) is reset to the first value as soon as the interval of time between two overshootings of the given range exceeds a predetermined value.

2. A circuit for the implementation of the method claimed in Claim 1, characterised in that a first counter (24) is provided for consecutive equivalent bits of the signal and a second counter (26) is provided for the interval of time between the overshootings determined in the first counter (24), that an output (QB) of the first counter (24) is connected to the first input of a NOR-gate (25), the output of which is connected to the input of the second counter (26) and the output (30) of which is connected to the second input of the NOR-gate (25), and that the first counter (24) is reset with each level transition of the binary signal or is preset at a specific state and the second counter (26) is reset as soon as the first counter (24) reaches a predetermined state.

## Revendications

1. Procédé de génération d'une valeur réponse (G) indiquant un signal utile à partir d'une séquence de signaux binaires comprenant alternativement des signaux utiles et des signaux parasites, la valeur réponse (G) indiquant, avec une première valeur (1), qu'un signal binaire utile est présent et, avec une seconde valeur (0) qu'un signal parasite binaire produit par amplification et par limitation pendant un défaut de signal est présent, le nombre de bits équivalents se succédant immédiatement se trouvant dans un domaine donné pour le signal utile, caractérisé en ce que le nombre de bits équivalents se succédant immédiatement de la séquence de signaux (A) est mesuré, et qu'à la suite d'un dépassement de la limite supérieure du domaine donné, la valeur réponse (G) est générée au moyen de la deuxième valeur (0) et que la valeur réponse (G) est remise à la première valeur, dès que l'écart temporel entre deux dépassements de la gamme donnée dépasse une valeur donnée.

2. Circuit pour la mise en oeuvre du procédé selon revendication 1, caractérisé en ce qu'un premier compteur (24) est prévu pour des bits équivalents d'un signal qui se succèdent, et qu'un second compteur (26) est prévu pour les dépassements déterminés dans le premier compteur (24), qu'une sortie (QB) du premier compteur (24) est reliée à la première entrée d'une porte NOR (25) dont la sortie est reliée à l'entrée du second compteur (26) et dont la sortie (3Q) est reliée à la deuxième entrée de la porte NOR (25), et que le premier compteur (24) est remis à zéro ou préréglé à une valeur déterminée pour chaque passage de niveau du signal binaire, et que le second compteur (26) est remis à zéro dès que le premier compteur (24) atteint une position de compteur donnée.
